# EUROPEAN PATENT SPECIFICATION

(11) **EP 1 691 400 B1**
(45) Date of publication and mention of the grant of the patent: **14.01.2009**
(21) Application number: 06002371.0
(22) Date of filing: 06.02.2006
(51) Int. Cl.: H01L 21/285, H01L 21/768, C23C 16/34, C23C 16/455

(54) **Preparation of metal silicon nitride films via cyclic deposition**
Herstellung von Metall-Siliziumnitridfilmen mittels zyklischer Abscheidung
Preparation d'un film de nitrure de silicium et de métal par déposition cyclique

(30) Priority: 14.02.2005 US 57446
(43) Date of publication of application: 16.08.2006
(73) Proprietor: Air Products and Chemicals, Inc., Allentown, PA 18195-1501 (US)
(72) Inventor: Lei, Xinjian, Vista, CA 92083 (US); Thridandam, Hareesh, Vista, CA 92081 (US); Cuthill, Kirk Scott, Vista, CA 92084 (US); Hochberg, Arthur Kenneth, Solana Beach, CA 92075 (US)
(74) Representative: Kador & Partner

(56) References cited:
- EP-A- 1 441 042
- US-A1- 2002 168 468
- US-A1- 2003 082 296
- US-A1- 2003 108 674
- US-A1- 2004 077 183
- US-A1- 2004 194 706
- US-B1- 6 426 117
- LIU ET AL: "Reactions of Tetrakis(dimethylamide)-Titanium, -Zirconium and -Hafnium with Silanes: Synthesis of Unusual Amide Hydride Complexes and Mechanistic Studies of Titanium-Silicon-Nitride (Ti-Si-N) Formation" J. AM. CHEM. SOC., vol. 123, no. 33, 2001, pages 8011-8021, XP002335039 Washington DC

## Description

### BACKGROUND OF THE INVENTION

Metal silicon nitride films are known and have been used in the semiconductor industry to provide a diffusion barrier for interconnects and they have been used as gate electrodes. Traditionally, aluminum has been used for interconnects in semiconductor devices, but recently, copper, with its lower resistance and better electromigration lifetime than that of aluminum, has been used for integration. However, copper is very mobile in many of the materials used to fabricate semiconductor devices and can diffuse quickly through certain materials including dielectrics. Electromigration of copper into the silicon substrate ruins device performance. Thus, it is necessary to have barrier layers in place to avoid any diffusion within the semiconductor device.

Metal nitride layers, e.g., titanium nitride (TiN) layers have been employed as barrier layers against diffusion, including copper diffusion, in semiconductor device structures, e.g., contacts, vias and trenches. However these barrier layers must be as thin as possible to accommodate the higher aspect ratios of today's devices. They must be inert and must not adversely react with adjacent materials during subsequent thermal cycles, must prevent the diffusion or migration of adjacent materials through it, must have low resistivity (exhibit high conductivity), low contact or via resistance and low junction leakage.

Barrier performance to copper diffusion as, for example, has been difficult to achieve. Metal silicon nitride films, particularly titanium-silicon-nitride layers have been found to provide a better diffusion barrier for aluminum or copper interconnects than titanium nitride barriers as silicon nitride blocks the grain boundaries in the metal nitride. The grain boundarie in the polycrystalline metal nitride provide diffusion pathway for copper atoms.

Currently in the formation of ternary films, a metal amide, silane, and ammonia are sequentially deposited on the substrate via cyclic deposition but the process poses processing issues. Silane is a pyrophoric gas and creates a potential safety hazard. In addition, three precursors are employed in the cyclic process requiring three deposition steps along with respective purge steps. On the other hand, aminosilane or hydrazinosilane and ammonia have been reported to form silicon nitride. Importantly, though, it has been found that in these films, there is no direct metal-silicon bond in the metal silicon nitride formed by either chemical vapor deposition or atomic layer deposition, implying metal nitride and silicon nitride are in separate phases in the resulting film, i.e., metal nitride is stuffed with silicon nitride.

The following patents and articles are representative of processes for producing metal-silicon nitride films and silicon nitride and their use in the electronics industry.

US 2004/0009336 discloses a process for forming a titanium silicon nitride (TiSiN) layer using a cyclical deposition process. In the cyclic deposition process a titanium-containing precursor, a silicon-containing gas and a nitrogen- containing gas are alternately adsorbed on a substrate. One exemplary process alternately provides pulses of tetrakis(dimethyamido)titanium, pulses of ammonia and silane to form the titanium silicon nitride (TiSiN) layer on the substrate.

USA 2004/0197492 discloses a method of forming a titanium silicon nitride barrier layer on a semiconductor wafer, comprising the steps of depositing a titanium nitride layer on the semiconductor wafer via vaporizing tetrakis(dimethylamino)titanium; plasma treating the titanium nitride layer in an N₂/H₂ plasma; and exposing the plasma-treated titanium nitride layer to a silane ambient. Silicon is incorporated into the titanium nitride layer as silicon nitride thereby forming a titanium silicon nitride barrier layer.

Alen, P., T, Aaltonen, M. Ritala, M. Leskela, T. Sajavaara, J. Keinonen, J. C. Hooker and J. W. Maes, ALD of Ta(Si)N Thin Films Using TDMAS as a Reducing Agent and as a Si Precursor, Journal of The Electrochemical Society 151(8): G523-G527 (2004) disclose the deposition of Ta(Si)N films by employing TaCl₅, NH₃ and tri(dimethylamino)silane (TDMAS) as the reactive species. Multiple pulsing sequences are disclosed, with the sequence TaCl₅, TDMAS, and NH₃ affording the best results.

US 2003/0190423 discloses a multiple precursor cyclical deposition system utilizing three or more precursors in which delivery of at least two of the precursors to a substrate structure at least partially overlap. Metal precursors of Ta, Ti and Hf such as pentadimethylamino tantalum and hafnium chloride are illustrative of metal precursors, silicon precursors include silane, chlorosilanes, and silicon chloride, and nitrogen precursors include ammonia and hydrazines.

US 2003/0190804 discloses a method for the simultaneous deposition of multiple compounds on a substrate in differing processing regions. In the process, a metal precursor, e.g., TiCl₄ or PDMAT is pulsed followed by the pulsing of a nitrogen compound. To enhance the deposition rate, doses of the first and second compounds initially are separated by a time delay and then at least one dose is effected where both the first and second compound are in fluid communication with the substrate surface.

US 6,426,117 discloses a method for forming a three-component film containing metal, silicon and nitrogen for use in semiconductor devices on a substrate. The method comprises the steps: preparing separate reactive gases consisting of a gaseous metal compound, a gaseous silicon compound and an ammonia gas under conditions such that the gaseous metal compound and the ammonia gas do not form a mixture. The examples show a process cycle wherein tetrakis(dimethylamido)titanium is introduced into a chamber, followed by ammonia gas and then silane. In another example the silane is mixed with the tetrakis(dimethylamido)titanium gas and deposited.

Marcadal, C., M. Eizenberg, A. Yoon and L. Chen, Metallorganic Chemical Vapor Deposited TiN Barrier Enhancement With SiH4 Treatment, Journal of The Electrochemical Society, 149: C52-C58 (2002) disclose the formation of a ternary TiSiN layer to enhance barrier resistance to copper diffusion in semiconductor application. The TiSiN films are prepared by chemical vapor deposition (CVD) using a metallorganic precursor (MOCVD-TiN) e.g., (dimethylamino)titanium (TDMAT), silane and a nitrogen source. In this process, TDMAT is deposited initially followed by plasma treatment with a gas mixture of nitrogen and finally, the deposited films are exposed to silane. This process route leads to the formation of a Si-N bond layer in the TiSiN film.

Min, J.-S., J.-S. Park, H.-S. Park and S.-W. Kang, The Mechanism of Si Incorporation and the Digital Control of Si Content During the Metallorganic Atomic Layer Deposition of Ti-Si-N Thin Films, Journal of The Electrochemical Society 147: 3868-3872 (2000) disclose the formation of titanium-silicon-nitride thin films by metallorganic atomic layer deposition (MOALD) using tetrakis(dimethylamido)titanium (TDMAT), ammonia, and silane as the precursors. When the reactants are injected into the reactor in the sequence of a TDMAT pulse, an SiH₄ pulse, and an NH₃ pulse, the Si content in the Ti-Si-N films is saturated at 18 atom %. By changing the sequence in the order of TDMAT, NH₃, and SiH₄, the Si content is increased to 21 atom %.

(US 2003/0108674 discloses an apparatus and a method for cyclical layer deposition of refractory metal silicon nitride utilizing three or more precursors added in pulses. In one embodiment the method includes introducing a pulse of a nitrogen-containing precursor first, followed by introducing a pulse of the refractory metal-containing precursor, introducing a further pulse of the nitrogen-containing precursor, and introducing a pulse of the silicon-containing precursor, the last three additions forming the at least one cycle needed.)

The following patents and articles are representative of processes for producing silicon nitride films.

Laxman, R.K., T.D. Anderson, and J.A. Mestemacher, "A low-temperature solution for silicon nitride deposition, in Solid State Technology p. 79-80 (2000) disclose a process to make silicon nitride using bis(tert-butylamino)silane and ammonia.

US 5,874,368 describes formation of silicon nitride at a temperature below 550°C using bis(tert-butylamino)silane and ammonia.

US 2004/0146644 discloses a method for forming silicon nitride employing hydrazinosilane with and without ammonia. All the silicon nitride processes so far have been deposited at temperature above 500°C.

(US 2004/0194706 discloses an apparatus and a method for forming a high quality low temperature silicon nitride layer. The silicon nitride layer is deposited by thermally decomposing a silicon/nitrogen containing source gas or a silicon containing source gas and a nitrogen containing source gas at reduced deposition temperature to form a silicon nitride layer.)

### BRIEF SUMMARY OF THE INVENTION

This invention relates to an improved process for producing ternary metal silicon nitride films by the cyclic deposition of the recited precursors. The improvement resides in the use of a metal amide and a silicon source having both NH and SiH functionality as the precursors leading to the formation of such metal-SiN films. The precursors are applied sequentially via cyclic deposition onto the surface of a substrate. Exemplary silicon sources are monoalkylaminosilanes and hydrazinosilanes represented by the formulas:

(R¹NH)ₙSiR²ₘH₄₋ₙ₋ₘ(n=1,2; m=0,1,2; n+m =<3);

and

(R³₂N-NH)ₓSiR⁴_{y}H_{4-x-y}(x=1,2; y=0,1,2; x+y=<3)

wherein in the above formula R¹⁻⁴ are same or different and independently selected from the group consisting of alkyl, vinyl, allyl, phenyl, cyclic alkyl, fluoroalkyl, silylalkyls.

Several advantages can be achieved through the practice of this invention, and some of advantages are as follows:
an ability to produce high quality ternary metal silicon nitride films;
an ability to form high quality films while eliminating some of the common precursors that present significant safety and corrosion issues; and, an ability to incorporate desirable silicon levels in TiN at temperatures generally below conventional processes, e.g., below 500 °C;
an ability to control the silicon content in the metal silicon nitride via the control of pulse time of a silicon source in a cyclic deposition process, e.g., a CVD process;
an ability to achieve excellent deposition rates in a cyclic CVD, thus making possible an increase of wafer throughput at production scale;
an ability to produce ultra-thin metal silicon nitride films employing ALD;
an ability to produce metal silicon nitride films using two precursors while eliminating the use of a separate nitrogen source, e.g., ammonia;
an ability to reduce the metal center in a resulting metal silicon, thus reducing the resisitivity of the resulting film; and,
an ability to increase the film stability by forming metal-nitrogen-silicon linkages in the resulting metal silicon nitride.

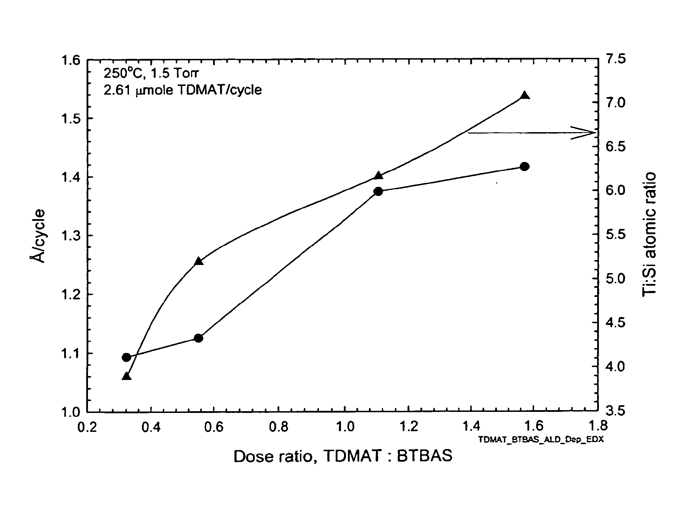

### BRIEF DESCRIPTION OF THE DRAWING

The drawing is a graph showing deposition rates and film compositions in ALD processes vs. the dose ratio of TDMAT to BTBAS.

### DETAILED DESCRIPTION OF THE INVENTION

This invention is related to an improvement in a process to produce ternary metal silicon nitride films via cyclic deposition. Sequential deposition of select precursors via chemical vapor deposition and atomic layer deposition techniques provide for excellent quality films and reduces the associated hazards associated with many precursor formulations.

The term "cyclical deposition" as used herein refers to the sequential introduction of precursors (reactants) to deposit a thin layer over a substrate structure and includes processing techniques such as atomic layer deposition and rapid sequential chemical vapor deposition. The sequential introduction of reactants results in the deposition of a plurality of thin layers on a substrate and the process is repeated as necessary to form a film layer having a desired thickness.

Atomic layer deposition is one form of cyclic deposition and comprises the sequential introduction of pulses of a first precursor and, in this case, a second precursor. In many of the prior art procedures, pulses of a third precursor were employed. For example, in an ALD process, there is the sequential introduction of a pulse of a first precursor, followed by a pulse of a purge gas and/or a pump evacuation, followed by a pulse of a second precursor, which is followed by a pulse of a purge gas and/or a pump evacuation. If necessary, or desired, there may be a pulse of a third precursor. Sequential introduction of separate pulses results in alternating self-limiting chemisorption of monolayers of each precursor on the surface of the substrate and forms a monolayer of the deposited materials for each cycle. The cycle may be repeated as necessary to generate a film of desired thickness.

The growth rate of ALD is very low compared to conventional CVD process. A typical growth rate of an ALD process is 1-2 Å/cycle. One approach to increase of growth rate is that of modification of the ALD process by operating at a higher substrate temperature than ALD, leading to a CVD-like process but still taking advantage of the sequential introduction of precursors. This process is called cyclic CVD.

Cyclic CVD deposition may also be used as a method for forming ternary films of desired composition and thickness. In this process the precursors (reactants) are introduced to the CVD chamber and vaporized onto a substrate. Subsequent reactants are supplied as in an ALD process but, of course, the individual film thicknesses in the cyclic CVD process are not limited to monolayers.

To facilitate an understanding of a cyclic deposition process for the formation of a ternary film as contemplated herein, a first precursor for deposition onto a substrate is a metal amide. Metals commonly used in semiconductor fabrication include and suited as the metal component for the metal amide include: titanium, tantalum, tungsten, hafnium, zirconium and the like. Specific examples of metal amides suited for use in the cyclic process include those metal amides selected from the group consisting of tetrakis(dimethylamino)titanium (TDMAT), tetrakis(diethylamino)titanium (TDEAT), tetrakis(ethylmethylamino)titanium (TEMAT), tetrakis(dimethylamino)zirconium (TDMAZ), tetrakis(diethylamino)zirconium (TDEAZ), tetrakis(ethylmethylamino)zirconium (TEMAZ), tetrakis(dimethylamino)hafnium (TDMAH), tetrakis(diethylamino)hafnium (TDEAH), tetrakis(ethylmethylamino)hafnium (TEMAH), *tert*-butylimino tris(diethylamino)tantalum (TBTDET), *tert*-butylimino tris(dimethylamino)tantalum (TBTDMT), *tert*-butylimino tris(ethylmethylamino)tantalum (TBTEMT), ethylimino tris(diethylamino)tantalum (EITDET), ethylimino tris(dimethylamino)tantalum (EITDMT), ethylimino tris(ethylmethylamino)tantalum (EITEMT), *tert*-amylimino tris(dimethylamino)tantalum (TAIMAT), *tert*-amylimino tris(diethylamino)tantalum, pentakis(dimethylamino)tantalum, *tert*-amylimino tris(ethylmethylamino)tantalum, bis(*tert-*butylimino)bis(dimethylamino)tungsten (BTBMW), bis(*tert-*butylimino)bis(diethylamino)tungsten, bis(*tert*-butylimino)bis(ethylmethylamino)tungsten, and mixtures thereof.

The metal amide is supplied to the deposition chamber at a predetermined molar volume and for a predetermined time. Typically, the metal amide is supplied to a CVD or ALD chamber for a period of 0.1 to 80 seconds to allow the material to be sufficiently adsorbed so as to saturate a surface. During deposition the metal amide preferably is in the gas phase and supplied in a predetermined molar volume typically in the range of 1 to 100 micromoles. Deposition temperatures are conventional and range from about 200 to 500 °C, preferably from 200 to 350 °C. Pressures of from 0.07 mbar to 133.3 mbar (50 mtorr to 100 torr) are exemplary.

In a second step of the process, and subsequent to the deposition of the metal amide, an inert gas, such as Ar, N₂, or He, is used to sweep unreacted metal amide from the chamber. Typically in a cyclic deposition process, a gas, such as Ar, N₂, or He, is supplied into the chamber at a flow rate of 50 to 2000 sccm, thereby purging the metal amide and any byproduct that remain in the chamber.

The second precursor employed in the cyclic deposition process is a silicon source and it is one which contains at least one reactive N-H fragment and at least one Si-H fragment. Both the N-H fragment and Si-H fragment are chemically reactive with the above recited metal amides, leading to formation of an M-N-Si linkage, e.g., a Ti-N-Si linkage and reduction of metal center by Si-H. One example of a silicon source suited for use in the cyclic deposition process is a monoalkylaminosilane having the formula:

(R¹NH)ₙSiR²ₘH₄₋ₙ₋ₘ(n=1,2; m=0,1,2; n+m=<3).

An alternative to the monoalkylaminosilane and suited as a silicon source for the cyclic deposition is a hydrazinosilane having the formula:

(R³₂N-NH)ₓSiR⁴_{y}H_{4-x-y}(x=1,2; y=0,1,2; x+y=<3)

wherein R¹⁻⁴ in the monoalkylaminosilane and hydrazine are the same or different and are independently selected from the group consisting of alkyl, vinyl, allyl, phenyl, cyclic alkyl, fluoroalkyl, silylalkyls, and ammonia. Alkyl functionality in the respective compounds typically will have from 1- 10 carbon atoms, although in preferred cases, the alkyl functionality has from 1-4 carbon atoms.

Examples of monoalkylamino silanes suited for use in the process include: bis(tert-butylamino)silane (BTBAS), tris(*tert*-butylamino)silane, bis(iso-propylamino)silane, and tris(iso-propylamino)silane. Examples of suitable hydrazinosilanes include: bis(1,1-dimethylhydrazino)silane, tris(1,1-dimethylhydrazino)silane, bis(1,1-dimethylhydrazino)ethylsilane, bis(1,1-dimethylhydrazino)isopropylsilane, bis(1,1-dimethylhydrazino)vinylsilane. Of the monoalkyaminosilanes and bis(*tert*-butylamino)silane is good example of a preferred reactant capable of supplying both nitrogen and silicon functionality and is a preferred monoalkylaminosilane.

The second precursor comprised of the silicon source having SH and NH is introduced into the chamber at a predetermined molar volume. e.g., from 1 to 100 micromoles for a predetermined time period, preferably about 0.1 to 100 seconds. The silicon precursor reacts with the metal amide and is adsorbed onto the surface of the substrate resulting in the formation of silicon nitride via metal-nitrogen-silicon linkage. Conventional deposition temperatures of from 200 to 500 °C and pressures of from 0.07 mbar to 133.3 mbar (50 mtorr to 100 torr) are employed.

Subsequent to the deposition of the silicon source, a gas, such as Ar, N₂, or He, is introduced into the chamber typically at a flow rate of 50 to 2000 sccm in order to purge the unreacted silicon source and byproducts from the deposition chamber. Sometimes, in order to purge the unreacted or byproducts, the purge gas may be continuously introduced during the entire deposition cycle.

Optionally, a third precursor that may be employed in the cyclic deposition process, particularly an ALD process which may require a nitrogen source such as ammonia or hydrazine These gases are used in order to produce nitrogen-rich film and further reduce the carbon content incorporated in the films in the aforementioned steps.

In carrying out the process, a suggested deposition cycle is as follows:
- 1.: expose vapors of a metal amide to a heated substrate loaded in a reaction or deposition chamber;
- 2.: allow the metal amide to react with the surface of the substrate,
- 3.: purge away the unreacted metal amide;
- 4.: introduce vapors of a monoalkylaminosilane or hydrazinosilane into the reaction chamber to react with the absorbed metal amide;
- 5.: purge away the unreacted monoalkylaminosilane or hydrazinosilane;
- 6.: if desired, introduce a nitrogen containing reactant, such as ammonia, into the reaction chamber,
- 7.: purge away the unreacted nitrogen containing reactant ; and,
- 8.: repeat the cycle as outlined above and until a desired film thickness is reached.

It is possible in the above cycle to reverse the order of precursor reactants introduced to the chamber, e.g., the silicon source may be introduced first followed by addition of the metal amide. However, higher deposition temperatures are generally required when the silicon source is deposited first. As stated, the metal amide generally deposits at lower temperatures than the silicon source and, further, catalytically facilitates its deposition at lower temperature.

Reaction scheme 1 below describes a typical two-reactant cyclic deposition process illustrating the chemical reactions using tetrakis(dimethylamino)titanium (TDMAT) and bis(tert-butylamino)silane (BTBAS) as an example. In that scheme, a silicon substrate is pre-treated initially to create reactive sites such as Si-OH, Si-H, and Si-NH fragments on the surface. Then the surface is exposed to a metal amide such as TDMAT under conditions for generating a chemical reaction between the reactive site and TDMAT, generating a surface occupied by Ti-NMe₂ fragments. Dimethylamine is released as by-product. Depending on whether the step is self-limiting, as in an ALD process, or non-limiting as in a cyclic CVD process; the chamber is purged with nitrogen to remove unreacted TDMAT and any by-products. At this point a silicon source such as BTBAS is introduced and allowed to react with the Ti-NMe₂ sites resulting in a surface covered with Si-H and Si-NH₂ sites. Butene and dimethylamine are released during this reaction. This step too, if self-limiting, is an ALD process and if it is not self limiting it is a cyclic CVD. The reaction is cycled until a desired film thickness is established.

Absorption of the Ti-NMe₂ is crucial to the formation silicon nitride because deposition of silicon nitride using BTBAS alone generally requires a substrate temperature over 500°C. A much lower temperature may be used when a metal amide is used in the deposition process as it acts to catalyze the deposition of silicon nitride.

The following is a description of the respective reactions in the cyclic deposition process.

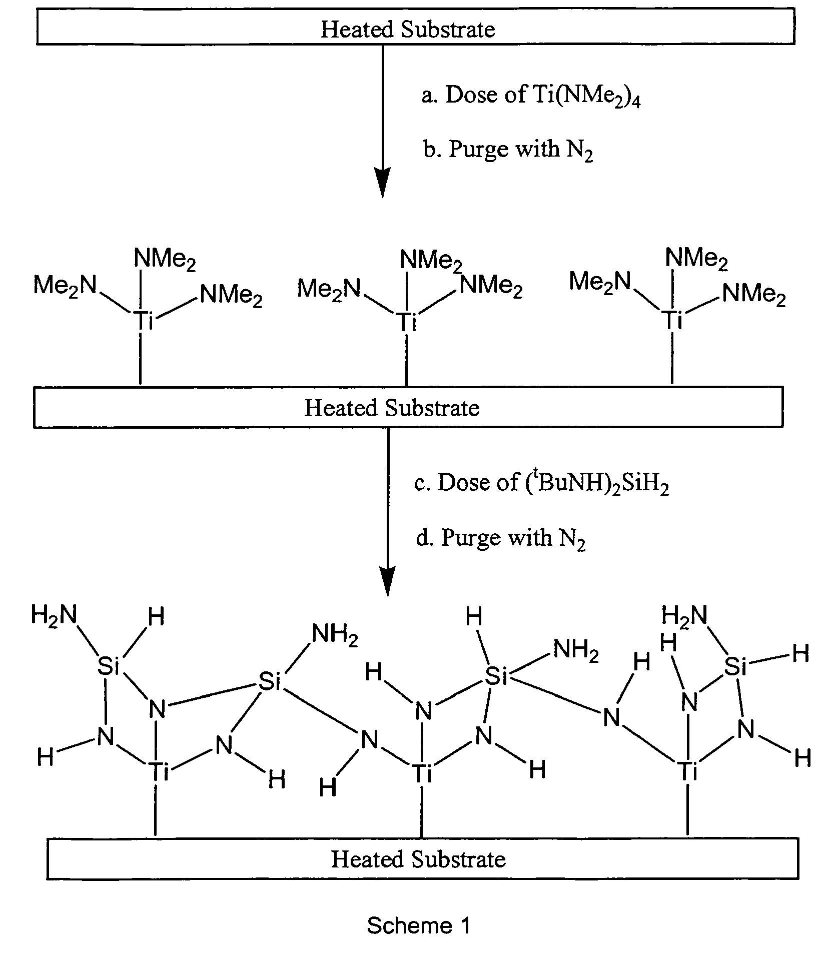

Reaction scheme 2 below describes a typical three-reactant process illustrating the chemistry using tetrakis(dimethylamino)titanium (TDMAT), ammonia, and bis(tert-butylamino)silane (BTBAS) as the precursors. A silicon substrate is pre-treated initially to create reactive sites such as Si-OH, Si-H, and Si-NH fragments on the surface. Then the surface is exposed to a metal amide such as TDMAT under conditions for generating a chemical reaction between the reactive sites and TDMAT, and creating a surface occupied by Ti-NMe₂ fragments. Dimethylamine is released as a by-product. Again, if this step is self-limiting it is an ALD, otherwise it is cyclic CVD process. Unreacted TDMAT and any by-product are removed from the chamber by purging with nitrogen. In contrast to reaction scheme 1, ammonia is introduced to convert all TiNMe₂ sites that were generated into Ti-NH₂ sites releasing dimethylamine. BTBAS is introduced to the deposition chamber to allow the reaction between the thus formed Ti-NH₂ sites and BTBAS resulting in a surface covered with Si-H and Si-NH₂. Butene, *tert*-butylamine, and dimethylamine are released in this step. If this latter step is self-limiting the process is a an ALD process, otherwise it is cyclic CVD process. The deposition cycle is repeated until desired film thickness is established.

The reaction chemistry is illustrated as reaction scheme 2.

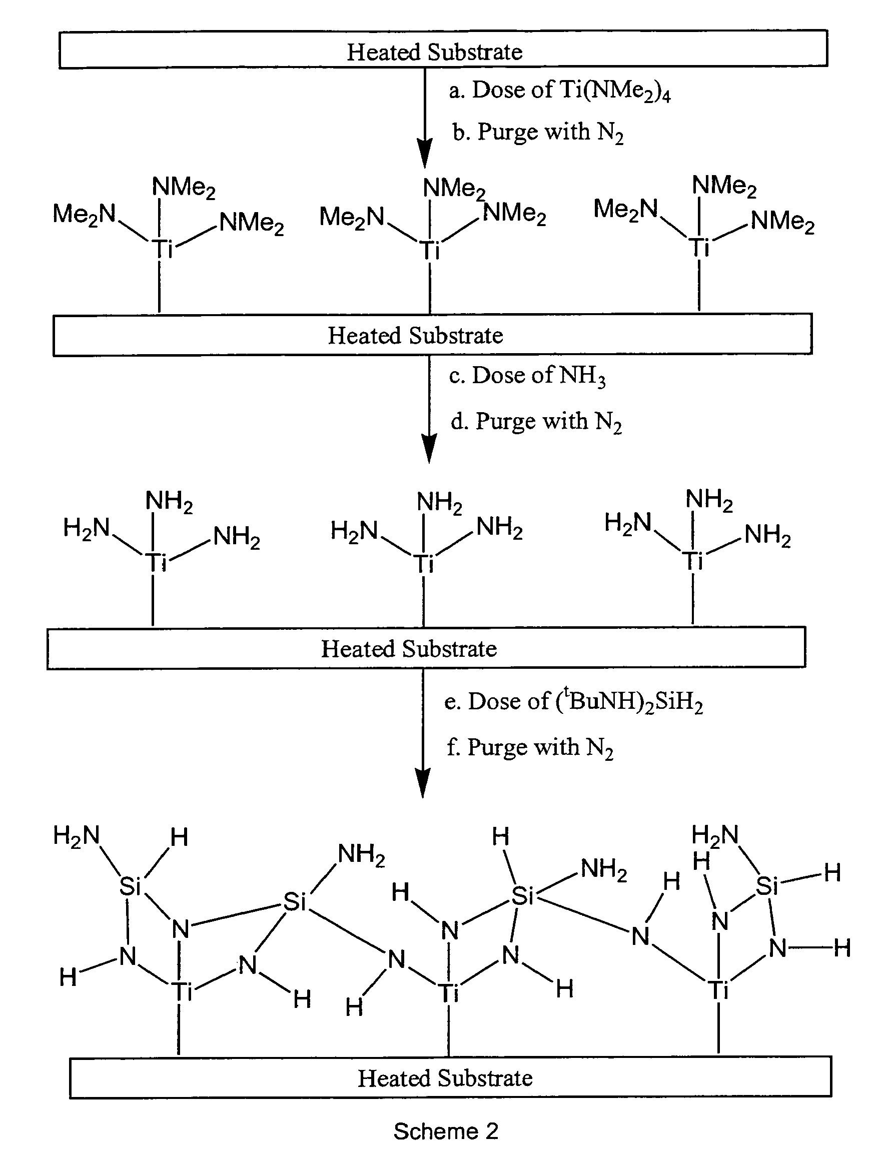

Reaction scheme 3 below describes a typical three-reactant process illustrating the chemistry using tetrakis(dimethylamino)titanium (TDMAT), and bis(tert-butylamino)silane (BTBAS), and ammonia as the precursors. A silicon substrate is pre-treated initially to create reactive sites such as Si-OH, Si-H, and Si-NH fragments on the surface. Then, the surface is exposed to a metal amide such as TDMAT under conditions for generating a chemical reaction between the reactive sties and TDMAT, generating a surface occupied by Ti-NMe₂ fragments. Dimethylamine is released as a by-product. Again, if this step is self-limiting it is an ALD, otherwise it is cyclic CVD process. Unreacted TDMAT and any by-products are removed from the chamber by purging with nitrogen. In contrast to reaction scheme 2, BTBAS is introduced to the deposition chamber to allow the reaction between the thus, formed Ti-NMe₂ sites and BTBAS resulting in a surface covered with Si-H and Si-NHBu^{t}. Tert-butylamine, butane, and dimethylamine are released in this step. If this latter step, too is self-limiting the process is a an ALD process, otherwise it is cyclic CVD process. ammonia is introduced to convert all Si-NHBu^{t} to reactive Si-NH₂ sites for the following cycle. The deposition cycle is repeated until desired film thickness is established.

The reaction chemistry is illustrated in reaction scheme 3.

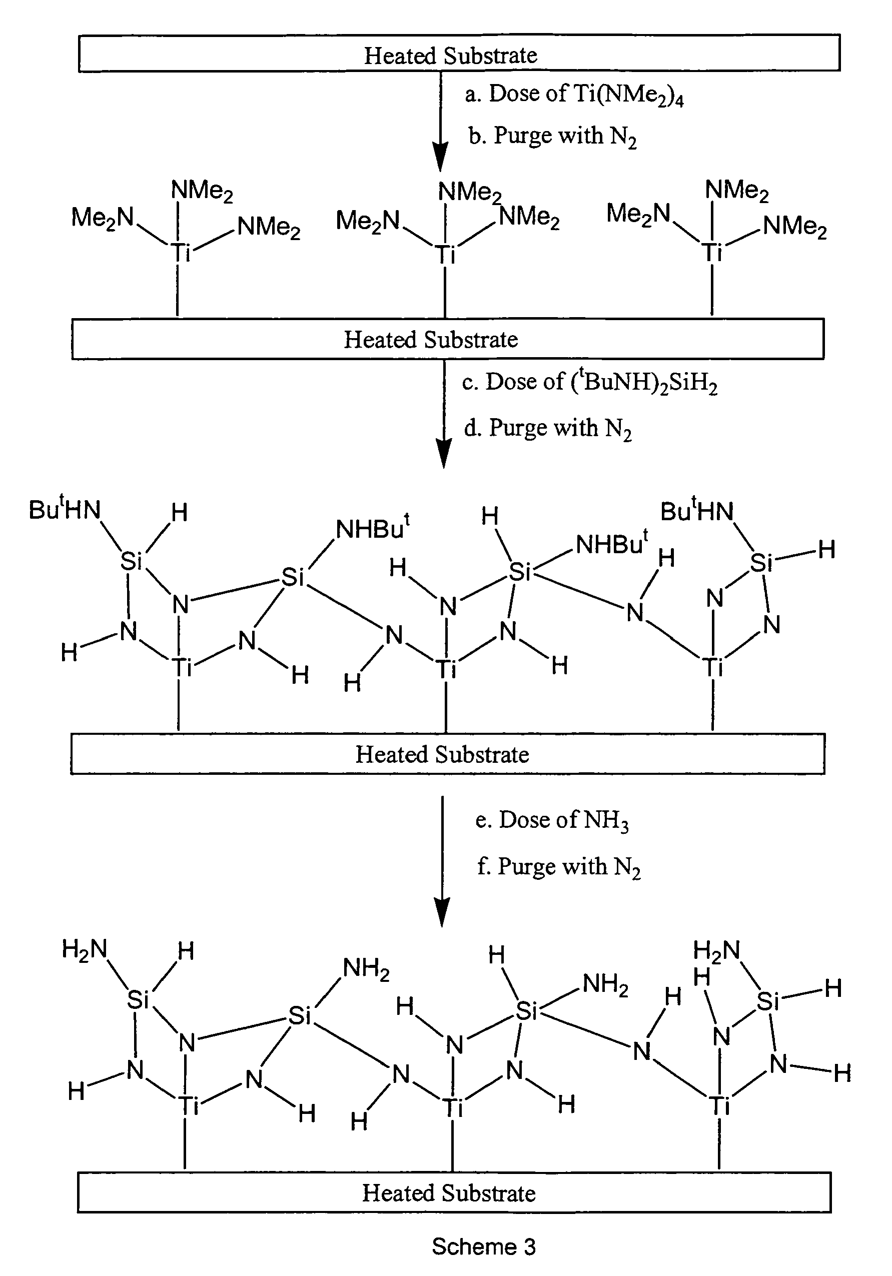

The following examples are provided to illustrate various embodiments of the invention and are not intended to restrict the scope thereof.

### Example 1

### Deposition of TiSiN Films From TDMAT and BTBAS At 200 °C

A silicon wafer is charged to a deposition chamber and maintained at a temperature of 200°C and a pressure of 200 Pa (1.5 Torr). A Ti-containing compound of 2.6 micromoles, tetrakis(dimethylamino)titanium (TDMAT), is introduced into the chamber over a period of 10 seconds pulse along with 100 sccm N₂. After deposition of the Ti amide, the unreacted Ti amide and byproducts are purged with 2000 sccm N₂ for 7.5 seconds. Then, a dose 4.73 micromoles of a Si-containing compound, bis(*tert-*butylamino)silane (BTBAS), is introduced over a period of 80 seconds along with 100 sccm N₂. Unreacted BTBAS and byproduct are removed by a 40 second purge with 2000 sccm of N₂.

The above cycle is repeated for 200 cycles (of the 4 steps) and a film of 45 Å thickness is generated. The deposition rate per cycle is 0.22 Å which is much lower than a typical ALD process, showing this temperature is insufficient for these precursors to achieve surface saturation.

### Example 2

### ALD Formation of TiSiN Films From TDMAT and BTBAS At 250 °C

The procedure of Example 1 is followed except that the silicon wafer is maintained at a temperature of 250 °C and a pressure of 200 Pa (1.5 Torr). A Ti-containing compound of 2.6 micromoles, tetrakis(dimethylamino)titanium (TDMAT) is introduced for 10 seconds into the chamber with 100 sccm N₂. A purge of 2000 sccm N₂ follows for 7.5 seconds. Then a dose 4.73 micromoles of a Si-containing compound, bis(*tert*-butylamino)silane (BTBAS), is introduced for 80 seconds along with 100 sccm N₂. This is followed by a 40 second purge with 2000 sccm of N₂. The cycle was repeated for 100 cycles (of the 4 steps) and a film of 144 Å thickness was generated.

The deposition rate per cycle is 1.44 Å which falls in the range for a typical ALD process, showing this temperature is sufficient to achieve monolayer surface saturation. The Ti to Si molar input ratio is 0.55 and the Ti to Si atomic ratio in the deposited film is analyzed as 5.2.

More experiments are carried out with different doses of TDMAT while keeping the BTBAS dose unchanged (see the drawing). The graph in the drawing shows that the film composition (Ti to Si ratio) in an ALD process may be modified by changing the dose ratio of the titanium and silicon reactants. Thus, a wide range of compositions may be obtained without changing the film thicknesses, significantly.

### Example 3

### Cyclic CVD Formation of TiSiN Films From TDMAT and BTBAS

The procedure of Example 1 is followed except the silicon wafer is maintained at a temperature of 300°C and a pressure of 200 Pa (1.5 Torr). A Ti-containing compound of 2.6 micromoles, tetrakis(dimethylamino)titanium (TDMAT), is introduced for 10 seconds into the chamber with 100 sccm N₂. A purge of 2000 sccm N₂ follows for 7.5 seconds. Then a dose 4.73 micromoles of a Si-containing compound, bis(*tert-*butylamino)silane(BTBAS), is introduced for 80 seconds along with 100 sccm N₂. This is followed by a 40 second purge with 2000 sccm of N₂. This is repeated for 100 cycles (of the 4 steps) and produces a film of 629 Å thickness. The rate per cycle is 6.29 Å, showing this temperature is too high to limit deposition to a monolayer per cycle. In contrast to Examples 1 and 2, a cyclic CVD-like process occurred at this temperature, leading to a deposition rate much higher than in an ALD process.

The Ti to Si molar input ratio is 0.55 and the Ti to Si atomic ratio in the deposited film is analyzed as 5.6.

### Example 4

### Cyclic CVD Using only BTBAS At 300 °C

The procedure of Example 3 is followed. A dose 4.73 micromoles of a Si-containing compound, bis(*tert*-butylamino)silane (BTBAS), is introduced for 80 seconds along with 100 sccm N₂. This is followed by a 40 second purge with 2000 sccm of N₂. This is repeated for 100 cycles (of the 4 steps) and produces no film, showing the absorbed metal amides are required to catalyze the CVD of silicon nitride at temperatures below 500 °C and the metal amides play a crucial role during the formation of metal silicon nitride.

### Example 5

### Cyclic CVD Using BTBAS and Ammonia At 300 °C

The procedure of Example 3 is followed. Ammonia (NH₃), is introduced for 10 seconds into the chamber with 100 sccm N₂. A purge of 2000 sccm N₂ follows for 7.5 seconds. Then a dose 4.73 micromoles of a Si-containing compound, bis(*tert-*butylamino)silane (BTBAS), is introduced for 80 seconds along with 100 sccm N₂. This is followed by a 40 second purge with 2000 sccm of N₂. This is repeated for 100 cycles (of the 4 steps) and does not produce a film. This example shows that absorbed metal amides are required to catalyze the decomposition of bis(*tert*-butylamino)silane (BTBAS) to form silicon nitride.

### Example 6

### ALD Formation of TaSiN Film From TBTDET and BTBAS At 350 °C

The procedure of Example 1 is followed except that the silicon wafer is maintained at a temperature of 350 °C and a pressure of 200 Pa (1.5 Torr). A Ta-containing compound of 1.1 micromoles, *tert*-butylimino tris(diethylamino)tantalum (TBTDET) is introduced for 20 seconds into the chamber with 50 sccm N₂. A purge of 500 sccm N₂ follows for 15 seconds. Then a dose 4.73 micromoles of a Si-containing compound, bis(*tert*-butylamino)silane (BTBAS), is introduced for 80 seconds along with 50 sccm N₂. This is followed by a 40 second purge with 500 sccm of N₂. The cycle was repeated for 200 cycles (of the 4 steps) and a film of 281 Å thickness was generated.

The deposition rate per cycle is 1.82 Å which falls in the range for a typical ALD process, showing this temperature is sufficient to achieve monolayer surface saturation.

### Example 7

### Cyclic CVD Formation of TaSiN Film From TBTDET and BTBAS

The procedure of Example 1 is followed except the silicon wafer is maintained at a temperature of 400°C and a pressure of 200 Pa (1.5 Torr). A Ta-containing compound of 1.1 micromoles, *tert*-butylimino tris(diethylamino)tantalum(TBTDET), is introduced for 20 seconds into the chamber with 50 sccm N₂. A purge of 500 sccm N₂ follows for 15 seconds. Then a dose 4.73 micromoles of a Si-containing compound, bis(*tert*-butylamino)silane(BTBAS), is introduced for 80 seconds along with 50 sccm N₂. This is followed by a 40 second purge with 500 sccm of N₂. This is repeated for 200 cycles (of the 4 steps) and produces a film of 2400 Å thickness. The rate per cycle is 12 Å, showing this temperature is too high to limit deposition to a monolayer per cycle. In contrast to Examples 6, a cyclic CVD-like process occurred at this temperature, leading to a deposition rate much higher than in an ALD process.

Summarizing the prior art and comparative example, as is known there has been intensive investigation on depositing titanium silicon nitride films using tetrakis(dimethylamino)titanium with silane or chlorosilane or tetrakis(diethylamino)titanium with ammonia and silane. In those processes, silane created safety issues and the chlorosilane created corrosive problems as well as safety issues. There has been also investigation on formation of tantalum silicon nitride film using TaCl₅, TDMAS, and ammonia. This process produces tantalum silicon nitride film contaminated with chloride which can lead to corrosion and other long-term stability problems.

In contrast to the prior art processes, Examples 1-7 provided herein show that the cyclic deposition of a metal amide and monoalkylamino silane as precursors in a cyclic deposition process leads to quality films while employing only two precursors instead of three. Further, the use of these precursors obviates some of the safety issues associated with the use of precursors such as silane.

## Claims

1. A cyclic deposition process to form a metal silicon nitride film on a substrate which comprises the steps:
introducing a metal amide to a deposition chamber and depositing a film on a heated substrate;
purging the deposition chamber to remove unreacted metal amide and any byproduct;
introducing a silicon compound containing an N-H fragment and an Si-H fragment to a deposition chamber and depositing a film on a heated substrate;
purging the deposition chamber to remove any unreacted compound and byproduct; and,
repeating the cyclic deposition process until a desired thickness of film is established.

2. The process of Claim 1 wherein the metal amide is selected from the group consisting of tetrakis(dimethylamino)titanium (TDMAT), tetrakis(diethylamino)titanium (TDEAT), tetrakis(ethylmethylamino) titanium (TEMAT), tetrakis(dimethylamino)zirconium (TDMAZ), tetrakis(diethylamino)zirconium (TDEAZ), tetrakis(ethylmethylamino) zirconium (TEMAZ), tetrakis(dimethylamino)hafnium (TDMAH), tetrakis(diethylamino)hafnium (TDEAH), tetrakis(ethylmethylamino)nafnium (TEMAH), *tert-*butylimino tris(diethylamino)tantalum (TBTDET), *tert*-butylimino tris(dimethylamino)tantalum (TBTDMT), *tert*-butylimino tris(ethylmethylamino)tantalum (TBTEMT), ethyllimino tris(diethylamino)tantalum (EITDET), ethyllimino tris(dimethylamino)tantalum (EITDMT), ethyllimino tris(ethylmethylamino)tantalum (EITEMT), *tert*-amylimino tris(dimethylamino)tantalum (TAIMAT), *tert*-amylimino tris(diethylamino)tantalum, pentakis(dimethylamino)tantalum, *tert*-amylimino tris(ethylmethylamino)tantalum, bis(*tert*-butylimino)bis(dimethylamino)tungsten (BTBMW), bis(tert-butylimino)bis(diethylamino)tungsten, bis(*tert-*butylimino)bis(ethylmethylamino)tungsten, and mixture thereof.

3. The process of Claim 2 wherein the silicon compound containing both an N-H fragment and an Si-H fragment is selected from the group consisting of a monoalkylaminosilane having a formula:
(R¹NH)ₙSiR²ₘH₄ₙ₋ₘ (n=1,2; m=0,1,2; n+m =<3);
and,
a hydrazinosilane having the formula
(R³2N-NH)ₓSiR⁴yH_{4-x-y} (x=1,2; y=0,1,2; x+y=<3)
wherein in the above formulas R¹⁻⁴ are the same or different and independently selected from the group consisting of alkyl, vinyl, allyl, phenyl, cyclic alkyl, fluoroalkyl, silylalkyls.

4. The process of Claim 3 where the metal silicon nitride is titanium silicon nitride.

5. The process of Claim 3 wherein the metal amide is selected from the group consisting of tetrakis(dimethylamino)titanium (TDMAT), tetrakis(diethylamino)titanium (TDEAT), tetrakis(ethylmethylamino)titanium (TEMAT).

6. The process of Claim 4 wherein the silicon compound containing an N-H and Si-H fragment is selected from the group consisting of bis(*tert*-butylamino)silane (BTBAS), tris(*tert*-butylamino)silane, bis(iso-propylamino)silane, tris(*iso-*propylamino)silane, bis(1,1-dimethylhydrazino)silane, tris(1,1-dimethylhydrazino)silane, bis(1,1-dimethylhydrazino)ethylsilane, bis(1,1-dimethylhydrazino)isopropylsilane, bis(1,1-dimethylhydrazino)vinylsilane.

7. The process of Claim 3 where the metal silicon nitride is tantalum silicon nitride.

8. The process of Claim 3 where the metal silicon nitride is tungsten silicon nitride.

9. The process of Claim 3 wherein the cyclic deposition process is a cyclic chemical vapor deposition process.

10. The process of Claim 3 wherein the cyclic deposition process is an atomic layer deposition process.

11. The process of Claim 3 wherein the pressure in the deposition chamber is from 0.07 mbar to 133.3 mbar (50 mtorr to 100 torr) and the temperature in said deposition chamber is below 500 °C.

12. The process of Claim 11 wherein ammonia is used as a third precursor and the sequence of addition is selected from the group consisting of metal amide-ammonia-monoalkylaminosilane and metal amide-monoalkylaminosilane-ammonia.

13. The process of Claim 12 wherein the resulting metal silicon nitride film is exposed to a plasma treatment to density the resulting metal silicon nitride film as well as to reduce the resistivity of the metal silicon nitride film.

## Patentansprüche

1. Zyklisches Abscheidungsverfahren für die Herstellung eines Metallsiliciumnitridfilms auf einem Substrat, das die Schritte aufweist:
Einführen eines Metallamids in eine Bedampfungskammer und Abscheiden eines Films auf einem erwärmten Substrat;
Spülen der Bedampfungskammer, so daß das unreagierte Metallamid und irgendein Nebenprodukt entfernt werden;
Einführen einer Siliciumverbindung, die ein N-H-Fragment und ein Si-H-Fragment enthält, in die Bedampfungskammer und Abscheiden eines Films auf einem erwärmten Substrat;
Spülen der Bedampfungskammer, so daß irgendeine unreagierte Verbindung und irgendein Nebenprodukt entfernt werden; und
Wiederholen des zyklischen Abscheidungsverfahrens, bis eine gewünschte Dicke des Films erzeugt ist.

2. Verfahren nach Anspruch 1, wobei das Metallamid aus der Gruppe ausgewählt ist, bestehend aus Tetrakis(dimethylamino)titanium (TDMAT), Tetrakis(diethylamino)titanium (TDEAT), Tetrakis(ethylmethylamino)titanium (TEMAT), Tetrakis(dimethyl-amino)zirconium (TDMAZ), Tetrakis(diethylamino)zirconium (TDEAZ), Tetrakis(ethylmethylamino)zirconium (TEMAZ), Tetrakis(dimethylamino)hafnium (TDMAH), Tetrakis(diethyl-amino)hafnium (TDEAH), Tetrakis(ethylmethylamino)hafnium (TEMAH), tert.-Butyliminotris(diethylamino)tantalum (TBTDET), tert.-Butyliminotris(dimethylamino)tantalum (TBTDMT), tert.-Butyliminotris(ethylmethylamino)tantalum (TBTEMT), Ethylliminotris(diethylamino)tantalum (EITDET), Ethylliminotris(dimethylamino)tantalum (EITDMT), Ethyllimi-notris(ethylmethylamino)tantalum (EITEMT), tert.-Amylimino-tris(dimethylamino)tantalum (TAIMAT), tert.-Amyliminotris(di-ethylamino)tantalum, Pentakis(dimethylamino)tantalum, tert.-Amyliminotris(ethylmethylamino)tantalum, Bis(tert.-butylimino)bis(dimethylamino)wolfram (BTBMW), Bis(tert.-butylimino)bis(diethylamino)wolfram, Bis(tert.-butylimino)bis(ethyl-methylamino)wolfram und einem Gemisch davon.

3. Verfahren nach Anspruch 2, wobei die Siliciumverbindung, die sowohl ein N-H-Fragment als auch ein Si-H-Fragment enthält, aus der Gruppe ausgewählt ist, die aus einem Monoalkylaminosilan der Formel:
(R¹NH)ₙSiR²ₘH₄₋ₙ₋ₘ (n = 1, 2; m = 0, 1, 2; n + m = <3)
und einem Hydrazinosilan mit der Formel
(R³2N-NH)ₓSiR⁴yH_{4-x-y} (x = 1, 2; y = 0, 1, 2; x + y = <3)
besteht,
wobei in den vorstehenden Formeln R¹⁻⁴ gleich oder verschieden sind und unabhängig voneinander aus der Gruppe ausgewählt sind, die aus Alkyl, Vinyl, Allyl, Phenyl, cyclischem Alkyl, Fluoralkyl, Silylalkylen besteht.

4. Verfahren nach Anspruch 3, wobei das Metallsiliciumnitrid Titansiliciumnitrid ist.

5. Verfahren nach Anspruch 3, wobei das Metallamid aus der Gruppe ausgewählt ist, bestehend aus Tetrakis(dimethylamino)titanium (TDMAT), Tetrakis(diethylamino)titanium (TDEAT), Tetrakis(ethylmethylamino)titanium (TEMAT).

6. Verfahren nach Anspruch 4, wobei die Siliciumverbindung, die ein N-H-Fragment und Si-H-Fragment enthält, aus der Gruppe ausgewählt ist, bestehend aus Bis(tert.-butylamino)silan (BTBAS), Tris(tert.-butylamino)silan, Bis(iso-propylamino)silan, Tris(iso-propylamino)silan, Bis(1,1-dimethylhydrazino)silan, Tris(1,1-dimethylhydrazino)silan, Bis(1,1-dimethylhydra-zino)ethylsilan, Bis(1,1-dimethylhydrazino)isopropylsilan, Bis(1,1-dimethylhydrazino)vinylsilan.

7. Verfahren nach Anspruch 3, wobei das Metallsiliciumnitrid Tantalsiliciumnitrid ist.

8. Verfahren nach Anspruch 3, wobei das Metallsiliciumnitrid Wolframsiliciumnitrid ist.

9. Verfahren nach Anspruch 3, wobei das zyklische Abscheidungsverfahren ein zyklisches chemisches Bedampfungsverfahren ist.

10. Verfahren nach Anspruch 3, wobei das zyklische Abscheidungsverfahren ein Abscheidungsverfahren atomarer Schichten ist.

11. Verfahren nach Anspruch 3, wobei der Druck in der Bedampfungskammer 0,07 bis 133,3 mbar (50 mtorr bis 100 torr) beträgt und die Temperatur in dieser Bedampfungskammer unter 500°C liegt.

12. Verfahren nach Anspruch 11, wobei der Ammoniak als dritte Vorläuferverbindung verwendet wird und die Reihenfolge der Zugabe aus der Gruppe ausgewählt ist, die aus Metallamid-Ammoniak-Monoalkylaminosilan und Metallamid-Monoalkylaminosilan-Ammoniak besteht.

13. Verfahren nach Anspruch 12, wobei der resultierende Metallsiliciumnitridfilm einer Plasmabehandlung ausgesetzt wird, so daß der resultierende Metallsiliciumnitridfilm dichter wird und auch der spezifische Widerstand des Metallsiliciumnitridfilms geringer wird.

## Revendications

1. Procédé de dépôt cyclique, pour former un film de nitrure de silicium et de métal sur un substrat, qui comprend les étapes consistant à :
introduire un amidure de métal dans une chambre de dépôt, et déposer un film sur un substrat chauffé ;
purger la chambre de dépôt pour éliminer l'amidure de métal n'ayant pas réagi et tout sous-produit ;
introduire un composé du silicium contenant un groupe N-H et un groupe Si-H dans une chambre de dépôt, et déposer un film sur un substrat chauffé ;
purger la chambre de dépôt pour éliminer tout composé n'ayant pas réagi et sous-produit ; et
répéter le procédé de dépôt cyclique jusqu'à ce que l'on obtienne une épaisseur de film requise.

2. Procédé selon la revendication 1, dans lequel l'amidure de métal est choisi parmi le groupe consistant en le tétrakis(diméthylamino)titane (TDMAT), le tétrakis(diéthylamino)titane (TDEAT), le tétrakis(éthylméthylamino)titane (TEMAT), le tétrakis(diméthylamino)zirconium (TDMAZ), le tétrakis(diéthylamino)zirconium (TDEAZ), le tétrakis(éthylméthylamino)zirconium (TEMAZ), le tétrakis(diméthylamino)hafnium (TDMAH), le tétrakis(diéthylamino)hafnium (TDEAH), le tétrakis(éthylméthylamino)hafnium(TEMAH), le tert-butylimino tris(diéthylamino)tantale (TBTDET), le tert-butylimino tris(diméthylamino)tantale (TBTDMT), le tert-butylimino tris(éthylméthylamino)taniale (TBTEMT), l'éthylimino tris(diéthylamino)tantale (EITDET), l'éthylimino tris(diméthylamino)tantale (EITDMT), l'éthylimino tris(éthylméthylamino)tantale (EITEMT), le tert-amylimino tris(diméthylamino)tantale (TAIMAT), le tert-amylimino tris(diéthylamino)tantale, le pentakis(diméthylamino) tantale, le tert-amylimino tris(éthylméthylamino) tantale, le bis(tert-butyilimino)bis(diméthylimino)tungstène (BTBMW), le bis(tert-butylimino)bis(diéthylamino)tungstène, le bis(tert-butylimino)bis(éthylméthylamino)tungstène et les mélanges de ceux-ci.

3. Procédé selon la revendication 2, dans lequel le composé du silicium contenant à la fois un groupe N-H et un groupe Si-H est choisi dans le groupe consistant en un monoalkylaminosilane de formule :
(R¹NH)ₙSiR²ₘH₄₋ₙ₋ₘ (n = 1 ou 2 ; m = 0, 1 ou 2 ; n+m ≤3) ;
et,
un hydrazinosilane correspondant à la formule :
(R³₂N-NH)ₓSiR⁴_{y}H_{4-x-y} (x = 1 ou 2 ; y = 0, 1 ou 2 ; x + y ≤3) ;
dans lequel, dans les formules ci-dessus, R¹⁻⁴ sont identiques ou différents, et sont indépendamment choisis parmi le groupe consistant en les groupes alkyle, vinyle, allyle, phényle, alkyle cyclique, fluoroalkyle et silylalkyle.

4. Procédé selon la revendication 3, dans lequel le nitrure de silicium et de métal est le nitrure de silicium et de titane.

5. Procédé selon la revendication 3, dans lequel l'amidure de métal est choisi parmi le groupe consistant en le tétrakis(diméthylamino)titane (TDMAT), le tétrakis(diéthylamino)titane (TDEAT) et le tétrakis(éthylméthylamino)titane (TEMAT).

6. Procédé selon la revendication 4, dans lequel le composé du silicium contenant un groupe N-H et un groupe Si-H, est choisi parmi le groupe consistant en le bis(tert-butylamino)silane (BTBAS), le tris(tert-butylamino)silane, le bis(iso-propylamino)silane, le tris(iso-propylamino)silane, le bis(1,1-diméthylhydrazino)silane, le tris(1,1-diméthylhydrazino)silane, le bis(1,1-diméthylhydrazino)éthylsilane, le bis(1,1-diméthylhydrazino)isopropylsilane et le bis(1,1-diméthylhydrazino)vinylsilane.

7. Procédé selon la revendication 3, dans lequel le nitrure de métal et de silicium est le nitrure de tantale et de silicium.

8. Procédé selon la revendication 3, dans lequel le nitrure de métal et de silicium est le nitrure de tungstène et de silicium.

9. Procédé selon la revendication 3, dans lequel le procédé de dépôt cyclique est un procédé de dépôt chimique cyclique en phase vapeur.

10. Procédé selon la revendication 3, dans lequel le procédé de dépôt cyclique est un procédé de dépôt de couche atomique.

11. Procédé selon la revendication 3, dans lequel la pression dans la chambre de dépôt est de 0,07 mbar à 133,3 mbars (de 50 mtorrs à 100 mtorrs), et la température dans ladite chambre de dépôt est inférieure à 500 °C.

12. Procédé selon la revendication 11, dans lequel on emploie de l'ammoniac comme troisième précurseur, et la séquence d'addition est choisie parmi le groupe consistant en l'amidure de métal-ammoniac-monoalkylaminosilane et l'amidure de métal-monoalkylaminosilane-ammoniac.

13. Procédé selon la revendication 12, dans lequel le film de nitrure de silicium et de métal résultant est exposé à un traitement par plasma pour densifier le film de nitrure de siliciuin et de métal résultant, ainsi que pour réduire la résistivité du film de nitrure de silicium et de métal.
